# EUROPÄISCHE PATENTSCHRIFT

(11) **EP 1 661 441 B1**
(45) Veröffentlichungstag und Bekanntmachung des Hinweises auf die Patenterteilung: **07.03.2007**
(21) Anmeldenummer: 04762603.1
(22) Anmeldetag: 30.07.2004
(51) Int. Cl.: H05K 5/02, G12B 17/06

(54) **SCHUTZVORRICHTUNG FÜR ELEKTRONISCHE KOMPONENTEN**
PROTECTION DEVICE FOR ELECTRONIC COMPONENTS
DISPOSITIF PROTECTEUR POUR COMPOSANTS ELECTRONIQUES

(30) Priorität: 01.09.2003 DE 10340895
(43) Veröffentlichungstag der Anmeldung: 31.05.2006
(73) Patentinhaber: SIEMENS AKTIENGESELLSCHAFT, 80333 München (DE)
(72) Erfinder: SAUERZWEIG, Hans-Joachim, 39221 Eickendorf (DE)
(86) Internationale Anmeldenummer: PCT/DE2004/001758
(87) Internationale Veröffentlichungsnummer: WO 2005/025285

(56) Entgegenhaltungen:
- DE-A- 3 611 990
- DE-C- 3 437 196
- DE-U- 29 904 858
- FR-A- 2 666 190
- GB-A- 956 001
- US-A- 3 880 007
- US-A- 5 739 463
- US-A1- 2003 109 612

## Beschreibung

Die Erfindung betrifft eine Schutzvorrichtung für elektronische Komponenten, insbesondere Speichermodule.
Elektronische Komponenten müssen häufig vor kurzzeitigen und auch lang andauernden Temperatureinflüssen, die sowohl während des Betriebes als auch bei Lagerhaltung auftreten können, wie auch vor den Einwirkungen starker mechanischer Belastungen geschützt werden. Dabei ist vornehmlich für die Ursachenforschung bei Unfällen im Verkehr der Erhalt des Inhaltes von elektronischen Speichern nach Extrembelastungen wie sie nach einem Brand, einer Explosion oder einem Zusammenstoß von Fahrzeugen auftreten, von eminenter Bedeutung. Flugschreiber, aus der Luftfahrt unter dem Begriff "Black Box" allgemein bekannt, erfüllen diese Aufgaben. Flugschreiber haben aber im Verhältnis zu den Kosten von Landfahrzeugen ein viel zu hohes Preisniveau. Die hohen Preise resultieren im Wesentlichen aus hochwertigen Materialien und aufwendigen Fertigungsprozessen.

Der Temperaturschutz sollte nach Möglichkeit ohne äußere Zwangskühlung gewährleistet sein. Schutzanforderungen werden durch Normen und Standards vorgegeben. Gemäß IEEE Standard 1482.1-1999 Abschnitt 4.5, Unterpunkt "Fire" gelten beispielsweise folgende Temperaturbeständigkeitsanforderungen: 650°C für 0,5 Stunden, 300°C für 1 Stunde und 100°C für 5 Stunden. Die Wirkung bekannter Isolationsmaterialien beruht auf deren schlechter Wärmeleitfähigkeit. Um mit diesen Materialien die oben genannte Temperaturbeständigkeit zu erreichen, muss die Wärmeisolierung ein Vielfaches des zu schützenden Elektronikvolumens einnehmen. Zur Verringerung des Isolationsvolumens sind aufwendige Konstruktionsmaßnahmen, insbesondere durch die Anordnung zusätzlicher Wärmereflektionsschichten und durch Anwendung des von der Thermosflasche bekannten Dewar-Prinzips, erforderlich. Ein weiterer Nachteil der bekannten Isolationsmaterialien mit sehr schlechter Wärmeleitfähigkeit besteht darin, dass die aufgrund des Leistungsumsatzes der Elektronik erforderliche Wärmeabführung erheblich erschwert wird.

Aus der DE 299 04 858 U1 ist eine Vorrichtung zur Messwerterfassung im Hochtemperaturbereich bekannt, bei der die elektronische Schaltung von wasseraufnahmefähiger Keramik umschlossen ist. Durch Ausnutzung der für die Verdampfung des Wassers notwendigen Energie für die Kühlung der Schaltung kann eine Arbeitstemperatur von maximal 125°C zeitweise toleriert werden.

Der Erfindung liegt die Aufgabe zugrunde, eine Schutzvorrichtung für elektronische Komponenten anzugeben, die einen in Anlehnung an die oben genannte IEEE 1482 ausreichenden Schutz bezüglich hoher Temperaturen und starker äußerer mechanischer Einwirkung sowie weitgehenden Schutz vor schädlichen Flüssigkeiten garantiert und die eine verbesserte Wärmeabführung von den elektronischen Komponenten nach Außen gestattet.

Die Aufgabe wird mit den kennzeichnenden Merkmalen des Anspruchs 1 gelöst. Durch die Einbettung silikonvergossener elektronischer Komponenten in eine Schutzhülle auf mineralischer Basis, welche einen Materialanteil mit hohem Wärmespeichervermögen, nämlich Wasser, aufweist, ist ein sehr wirkungsvoller Temperaturschutz gegeben, wobei gleichzeitig die Wärmeabführung von den elektronischen Komponenten gegenüber den bekannten Isolationsmaterialien mit sehr schlechter Wärmeleitfähigkeit erleichtert ist. Vorzugsweise sind die elektronischen Komponenten in ein 2-Komponenten-Silikon mit Edelstahlummantelung eingebettet. Das Silikon übernimmt die Aufgabe der elektrischen Isolierung, des Schutzes vor mechanischen Schwingungen und der Fixierung der Elektronik.

Üblicherweise wird dieses System - auch ohne Edelstahlummantelung - in einem Material eingebettet, das durch Phasenübergang eine hohe Wärmekapazität aufweist und schädliche äußere Wärme von der Elektronik durch Wärmeabsorption fernhält. Diese Materialien sind oft Wachse, Parafine, Ester oder Bicarbonate mit den bekannten Nachteilen der schwierigen Verarbeitbarkeit, den hohen Kosten und erheblichen Umweltbelastungen.

Erfindungsgemäß ist das Einbettungsmaterial ein Mineralsystem mit hohem Luftanteil, in dem Wasser gebunden ist, wobei ein Frostschutzmittel, beispielsweise Salz, dafür sorgt, dass der Korpus auch bei Minustemperaturen nicht beschädigt wird. Wasser besitzt - wie allgemein bekannt - die beste Wärmekapazität. Gegenüber häufig verwendeten keramischen Isolationsmedien zeichnen sich Isolatoren auf mineralischer Basis durch geringere Kosten, niedrigeres Gewicht und verbesserte Umweltverträglichkeit aus.

Unter Berücksichtigung zusätzlicher mechanischer Widerstandsfähigkeit, der nötigen Wärmeableitung aus dem Inneren und eines definierten Temperatur-Zeit-Verhaltens, das aus den speziellen Einsatzbedingungen resultiert, ist die Schutzhülle gemäß Anspruch 2 vorzugsweise von einem Edelstahlgehäuse, welches mindestens ein Thermostatventil aufweist, umgeben. Das Thermostatventil wirkt dabei als thermische Sollbruchstelle. Im Extremfall, insbesondere bei starker, lang andauernder Hitzeeinwirkung von außen, nimmt das Wasser zunächst die von außen zugeführte Wärme auf, erhitzt sich bis zur Siedetemperatur, geht unter weiterer Wärmeabsorption in die Dampfphase über und dringt durch die thermische Sollbruchstelle in das Umgebungsmedium ein. Dabei steigt die Temperatur in der Elektronik nicht über die Siedetemperatur des Wassers, d. h. nicht über ca. 100°C. Erst nachdem der gesamte Wasservorrat "verbraucht" ist, nimmt die Schutzhülle ihre ursprüngliche Funktion der Hemmung des Wärmeflusses ein.

Das Edelstahlgehäuse mit der Schutzhülle und der silikonvergossenen Elektronikkomponente kann gemäß Anspruch 3 in eine weitere Schutzhülle aus oder mit keramischer Gussmasse eingebettet sein. Diese Gussmasse übernimmt neben einem mechanischen Schutz auch eine Aufgabe beim thermischen Schutz, darin bestehend, selbst ein schlechter Wärmeleiter zu sein, bei Erwärmung gebundenes Wasser freizusetzen und den Dampf aus dem Thermoventil langsam nach außen zu leiten. Das freigesetzte Wasser unterstützt hierbei die Wärmeabsorption.

Als äußerer Abschluss ist gemäß Anspruch 4 ein weiteres Edelstahlgehäuse vorgesehen, das dem mechanischen Schutz der inneren Komponenten und der Fixierung des Gesamtsystems dient. Die Edelstahlummantelung der silikonvergossenen Elektronikkomponente und die beiden Edelstahlgehäuse für das mineralbasierte Isolationsmedium und für die keramische Gussmasse übernehmen nicht nur die Funktion des Trägers der Schutzhüllen. Sie sind auch in Verbindung mit den Schutzhüllen so ausgelegt, dass von außen eindringende Festkörper gehemmt, auftretende statische Drücke, extrem starke Beschleunigungen, von außen einwirkende schädigende Flüssigkeiten und Chemikalien, wie Wasser Öle, Kraftstoffe, Feuerschutzmittel usw. in Anlehnung an oben genannte IEEE 1482.1 von den elektronischen Komponenten ferngehalten werden.

Eine derartige Schutzvorrichtung beansprucht nur einen Bruchteil des Volumens bei Standardtemperaturschutzbauweise und erlaubt darüber hinaus eine kostengünstige Herstellung.

Die Erfindung wird nachfolgend anhand figürlich dargestellter Ausführungsbeispiele näher erläutert. Es zeigen:
- Figur 1: eine Wärmeschutzvorrichtung nach einem Test,
- Figur 2: Komponenten einer Wärmeschutzvorrichtung,
- Figur 3: einen Querschnitt durch eine Schutzvorrichtung mit einer Schutzhülle und
- Figur 4: einen Querschnitt durch eine Schutzvorrichtung mit zwei Schutzhüllen.

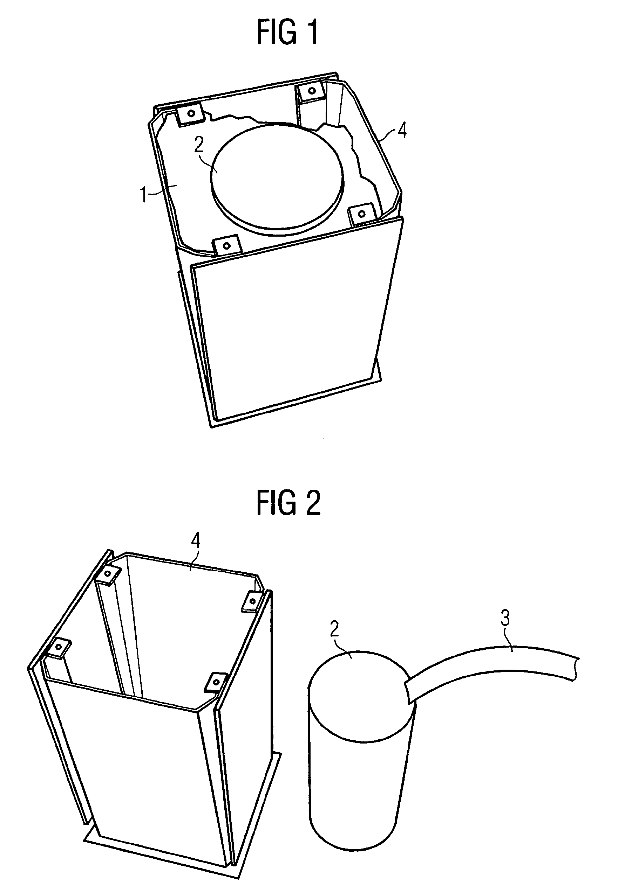

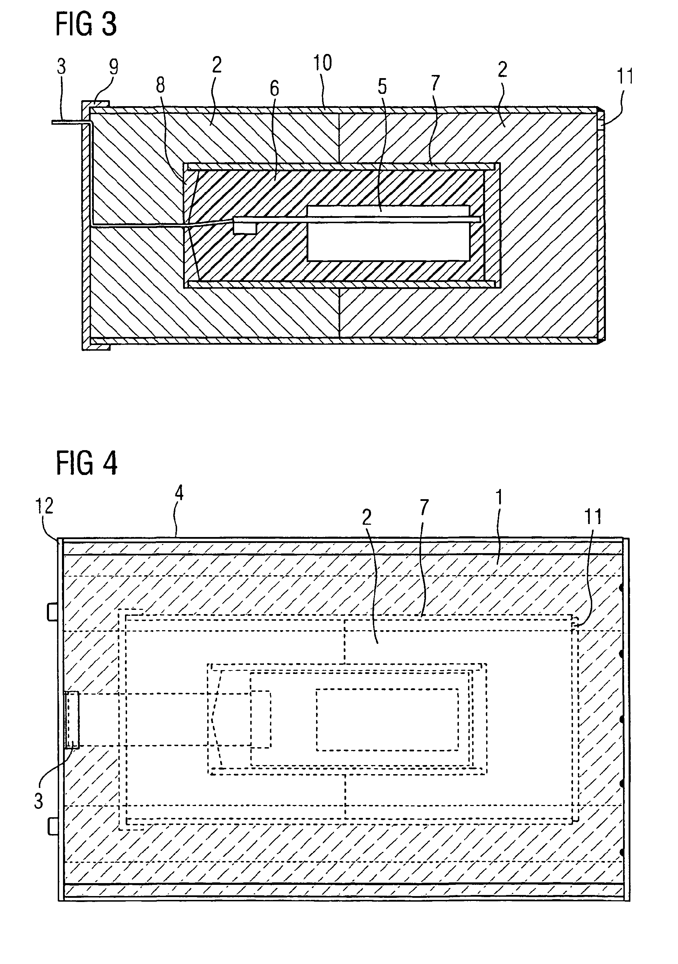

Die Figuren 1 und 2 zeigen die wesentlichen Bauteile einer Wärmeschutzvorrichtung mit einer topfförmigen zweiten Schutzhülle 1 und einer klotzförmigen ersten Schutzhülle 2, in die eine elektronische Komponente, beispielsweise ein elektronisches Speichermodul 5 (Figuren 3 und 4) vergossen ist, wobei in Figur 2 nur die nach außen geführte Anschlussleitung 3 des elektronischen Speichermoduls sichtbar ist. Die klotzförmige erste Schutzhülle 2 wird in das Innere der topfförmigen zweiten Schutzhülle 1 eingesetzt. Dabei kann die zweite Schutzhülle 1 beispielsweise durch ein Edelstahlgehäuse 4 gehalten sein. Die klotzförmige erste Schutzhülle 2 besteht aus Material mit hohem Wärmespeichervermögen, während die topfförmige zweite Schutzhülle 1 aus Material mit schlechter Wärmeleitfähigkeit besteht. Bei diesem Materialmix ist gesichert, dass einerseits eine hohe Temperaturbeständigkeit der Wärmeschutzvorrichtung gegeben ist und andererseits die Abführung der Leistungsverlustwärme von dem Speichermodul 5 nicht unnötig erschwert ist. Die Klotzform der ersten Schutzhülle 2 kann passgenau an die Topfform der zweiten Schutzhülle 1 angepasst sein. Denkbar sind jedoch auch Varianten mit Zwischenräumen, die durch Vakuum, Befüllung mit weiterem Isolationsmaterial oder durch Wärmereflektionsschichten teilweise oder ganz gefüllt sind.

Einen Querschnitt durch eine Schutzvorrichtung mit nur einer Schutzhülle veranschaulicht Figur 3. Das elektronische Speichermodul 5 ist in einer Silikonvergussmasse 6 eingebettet, welche von einer Edelstahlummantelung 7 mit Deckel 8 umschlossen ist. Die Anschlussleitung 3 des elektronischen Speichermoduls 5 durchragt die Silikonvergussmasse 6, den Deckel 8, die erste Schutzschicht 2 sowie eine Abdeckung 9 eines ersten Edelstahlgehäuses 10. Die erste Schutzhülle 2 besteht dabei aus einem Wärme-Isolationsmedium auf mineralischer Basis, wobei das mineralische Trägermaterial einen Luftanteil und gebundenes Wasser, das mit einem Frostschutzmittel am Vereisen gehindert wird, enthält. Das erste Edelstahlgehäuse 10 ist mit einem Thermoventil 11 ausgestattet, welches im Falle sehr hoher Wärmebelastung die Ableitung von Wasserdampf in die Umgebung ermöglicht.

Diesen Aufbau um 90° gedreht und mit einer zusätzlichen zweiten Schutzhülle 1 zeigt Figur 4. Die zweite Schutzhülle 1 besteht dabei im Wesentlichen aus einer keramischen Vergussmasse, in deren Poren über das Thermoventil 11 gegebenenfalls Wasserdampf eindringen kann. Die keramische Vergussmasse als zweite Schutzhülle 1 wird von dem zweiten Edelstahlgehäuse 4 samt einer Deckelung 12 allseitig umschlossen.

Die Erfindung beschränkt sich nicht auf die vorstehend angegebenen Ausführungsbeispiele. Vielmehr ist eine Anzahl von Varianten denkbar, welche auch bei grundsätzlich anders gearteter Ausführung von den Merkmalen der Erfindung Gebrauch machen.

## Patentansprüche

1. Schutzvorrichtung enthaltend mindestens eine elektronische Komponente (5), insbesondere ein Speichermodul,
**dadurch gekennzeichnet,**
**dass** die elektronische(n) Komponente(n) (5) silikonvergossen in einer ersten Schutzhülle (2) auf mineralischer Basis mit frostgeschütztem Wasser eingebettet ist/sind.

2. Schutzvorrichtung nach Anspruch 1,
**dadurch gekennzeichnet,**
**dass** die erste Schutzhülle (2) von einem ersten Edelstahlgehäuse (10), das mindestens ein Thermostatventil (11) aufweist, umgeben ist.

3. Schutzvorrichtung nach Anspruch 2,
**dadurch gekennzeichnet,**
**dass** das erste Edelstahlgehäuse (10) mit der ersten Schutzhülle (2) in eine zweite Schutzhülle (1) mit keramischer Gussmasse eingebettet ist.

4. Schutzvorrichtung nach Anspruch 3,
**dadurch gekennzeichnet,**
**dass** die zweite Schutzhülle (1) von einem zweiten Edelstahlgehäuse (4) umgeben ist.

## Claims

1. Protective apparatus containing at least one electronic component (5), in particular a memory module,
**characterized**
**in that** the electronic component or components (5) is/are embedded in a first protective sleeve (2) on a mineral base with frost-protected water, encapsulated in silicone.

2. Protective apparatus according to Claim 1,
**characterized**
**in that** the first protective sleeve (2) is surrounded by a first stainless-steel housing (10) which has at least one thermostatic valve (11).

3. Protective apparatus according to Claim 2,
**characterized**
**in that** the first stainless-steel housing (10) is embedded with the first protective sleeve (2) in a second protective sleeve (1) with a ceramic encapsulation compound.

4. Protective apparatus according to Claim 3,
**characterized**
**in that** the second protective sleeve (1) is surrounded by a second stainless-steel housing (4).

## Revendications

1. Dispositif de protection comprenant au moins un composant (5) électronique, notamment un module un mémoire,
**caractérisé**
**en ce que** le ou les composants (5) électroniques est ou sont incorporé(s), en étant coulé(s) dans de la silicone, dans une première enveloppe (2) de protection à base minérale ayant de l'eau additionnée d'un antigel.

2. Dispositif de protection suivant la revendication 1,
**caractérisé**
**en ce que** la première enveloppe (2) de protection est entourée d'un premier boîtier (10) en acier fin, qui a au moins une vanne (11) de thermostat.

3. Dispositif de protection suivant la revendication 2,
**caractérisé**
**en ce que** le premier boîtier (10) en acier fin est incorporé avec la première enveloppe (2) de protection dans une deuxième enveloppe (1) de protection ayant une masse coulée en céramique.

4. Dispositif de protection suivant la revendication 3,
**caractérisé**
**en ce que** la deuxième enveloppe (1) de protection est entourée d'un deuxième boîtier (4) en acier fin.
